# EUROPEAN PATENT SPECIFICATION

(11) **EP 0 989 211 B1**
(45) Date of publication and mention of the grant of the patent: **11.08.2004**
(21) Application number: 97921011.9
(22) Date of filing: 16.04.1997
(51) Int. Cl.: C30B 25/10, C23C 16/26

(54) **PROCESS FOR OBTAINING DIAMOND LAYERS BY GASEOUS-PHASE SYNTHESIS**
VERFAHREN ZUR HERSTELLUNG VON DIAMANTSCHICHTEN MITTELS GASPHASENSYNTHESE
PROCEDE DE PRODUCTION DE PELLICULES DE DIAMANT SELON LA METHODE DE SYNTHESE EN PHASE VAPEUR

(43) Date of publication of application: 29.03.2000
(73) Proprietor: OOO "Vysokie Tekhnologii", Moscow, 119989 (RU)
(72) Inventor: RAKHIMOV, Alexandr Tursunovich, Moscow, 119121 (RU); TIMOFEEV, Mikhail Arkadievich, Moscow, 127484 (RU); SUETIN, Nikolaiy Vladislavovich, Elektrostal, 144005 (RU); TUGAREV, Valentin Akimovich, Moscow, 121108 (RU)
(74) Representative: Einsel, Martin, Dipl.-Phys.
(86) International application number: PCT/RU1997/000115
(87) International publication number: WO 1998/046812

(56) References cited:
- EP-A- 0 324 538
- EP-A- 0 388 861
- WO-A-87/03307
- WO-A-92/05110
- DE-A- 3 927 136
- DE-B- 2 252 343
- US-A- 5 587 013
- KONOV V I ET AL: "D.C. ARC PLASMA DEPOSITION OF SMOOTH NANOCRYSTALLINE DIAMOND FILMS" DIAMOND AND RELATED MATERIALS,NL,ELSEVIER SCIENCE PUBLISHERS, AMSTERDAM, vol. 4, no. 8, 1 June 1995 (1995-06-01), pages 1073-1078, XP000627501 ISSN: 0925-9635
- POLUSHKIN V.M. ET AL: 'Diamond film deposition by downstream d.c. glow discharge plasma chemical vapour deposition' DIAMOND AND RELATED MATERIALS vol. 3, 1994, pages 531 - 533

## Description

The invention pertains to a method to produce a diamond film by chemical vapour deposition, comprising the maintenance of a DC glow discharge in a flow of hydrogen in a discharge gap between a cathode and an anode, the heating of a substrate up to the deposition temperature, the admixing of a carbon containing gas into the flow of hydrogen, the deposition of a diamond film in the mixture of hydrogen and the carbon containing gas, and the removal of a surplus graphite phase in a discharge in the hydrogen flow.

There are known various methods for the deposition of diamond films on a substrate. For example, V. I. Konov et al, "*D.C. Arc Plasma Deposition of Smooth Nanocrystalline Diamond Films*", in: Diamond and Related Materials 4 (1995), pages 1073 to 1078 suggests the chemical vapour deposition featuring a d. c. arc plasma. The purpose of this type of deposition is the providing of a diamond film for use as a hard protective and antifriction coating and insulating or semi conducting layer in electronic devices.

From "*Diamond based field emission flat panel displays*", in: Solid State Tech. (1995), May, page 71, there is known a method of amorphous diamond film deposition on a cold substrate by a laser ablation of the carbon target. But this method is rather complex and expensive, and it has limited opportunity for scaling. It gives also a low density of emission sites (of the order 10⁷ per m² at fields of 20 V / µm), that is obviously insufficient for the creation of a full colour monitor with 256 gradation of brightness, see "*Field Emission Characteristics Requirements for Field Emission Displays*", in: 1994 Int. Display Res. Conf., Soc. for Information Display, October 1994.

V. M. Polushkin et al, "*Diamond Film Deposition by Downstream D. C. Glow Discharge Plasma Chemical Vapour Deposition*", in: Diamond and Related Materials 3 (1994), pages 531 to 533 suggest a chemical vapour deposition method for forming diamond films which includes: the maintenance of the DC glow discharge in the hydrogen flowing through a gap between cathode and anode, heating of the substrate up to a deposition temperature, admission of carbon containing gas in the flow and deposition of a diamond film in a mixture of the hydrogen with the carbon containing gas, removal of a graphite surplus in the discharge in a hydrogen flow. The discharge current density is about 10000 A/m², the substrate temperature reaches the value of about 1000 °C. Deposition is carried out in a gas flow of a hydrogen - methane mixture at the methane concentration within the range of 0.3 to 3 %. At such parameters diamond films have a polycrystalline structure with micrometer size of the crystallines.

A basis for use of diamond materials as cold electron emitter is the negative electron affinity inherent to the diamond, see F. J. Himpsel et al., in: Phys. Rev., B 20 (2) 624 (1979). However, the diamond films described above do not have emission properties sufficient for creation of the cathode for a full colour monitor because their emission sites density is not higher than 10⁷ per m² (1000 per cm²), see A. Feldman et al (editors), "*Application of Diamond Films and Related materials*", in: Third International Conference NIST Special Publication 885, page 37, page 61, while it is required to have more than 10⁹ emission sites per m² (100000 per cm²).

Until now all attempts to create a highly effective electron emitter on the basis of a polycrystalline diamond film had no success, in particular, because of the low value of the emission sites density, see A. Feldman et al. cited above.

Therefore, it is the object of the present invention to provide a method to produce a diamond film having a more effective electron emission characteristic.

This object is solved in that the substrate is heated up to the temperature of 700 °C to 900 °C, that the deposition of the diamond film is conducted at a current density of 3000 to 20000 A/m² (0.3 to 2 A/cm²) and that the deposition of the diamond film is conducted at a concentration of a carbon containing gas in the gas flow of 3 to 10 %:

With this method it is possible to form highly effective films to be used for field emission of electrons, which could be used for manufacturing of flat panel displays, in electronic microscopy, microwave electronics and a number of other applications. Therefore, the indicated goal of producing diamond films by chemical vapour deposition is achieved.

Preferably, the carbon containing gas is methane at a concentration in the gas flow of 3 % to 8 %.

Also preferred is the deposition of the diamond film on a substrate placed on a grounded or insulated substrate holder outside of the discharge gap in a distance of 0.1 mm to 5 mm apart from an anode, and that the anode temperature is 1200 °C to 2000 °C and the methane concentration in the gas flow is 3 % to 8 %, until the desired film thickness is achieved.

Particularly preferred, in this case this deposition is made on a dielectric or conductive substrate.

It is further preferred if the anode is made from a molybdenum wire 0.1 mm to 1 mm thick forming a grid with a spacing of 1 mm to 3 mm.

Alternatively or additionally, the deposition of the diamond film is made on a conductive substrate placed on an anode at a methane concentration in the gas flow of 3 % to 8%, until the desired film thickness is achieved.

Further, a method is preferred which is characterized in that the deposition of the diamond film is made on a silicon substrate where prior to the film deposition a native oxide is removed from the substrate surface in a hydrogen flow, that then a silicon carbide layer is formed during 10 to 20 minutes on the substrate surface due to admixing into the gas flow of 7 % to 12 % of methane, and that the deposition of a diamond film is then sequentially performed at a methane concentration in the gas flow of 3 % to 8%until the desired film thickness is achieved.

This method is preferably performed when the removal of the native oxide is made during 10 to 20 minutes in a hydrogen flow at discharge current density of 3000 to 20000 A/m² (0.3 to 2 A/cm²). Alternatively or additionaily, the forming of the silicon carbide layer is made at a discharge current density of 3000 to 20000 A/m² (0.3 to 2 A/cm²).

A better understanding of the present invention is given by the Figures 1 to 4, where
- **Figure 1**: is a sketch of the apparatus to be used for chemical vapour deposition by this method,
- **Figure 2**: shows the placement of the substrate under the anode,
- **Figure 3**: shows the placement if the substrates on the anode,
- **Figure 4**: shows a scanning electron microscope image of the diamond film deposited by the method of this invention.

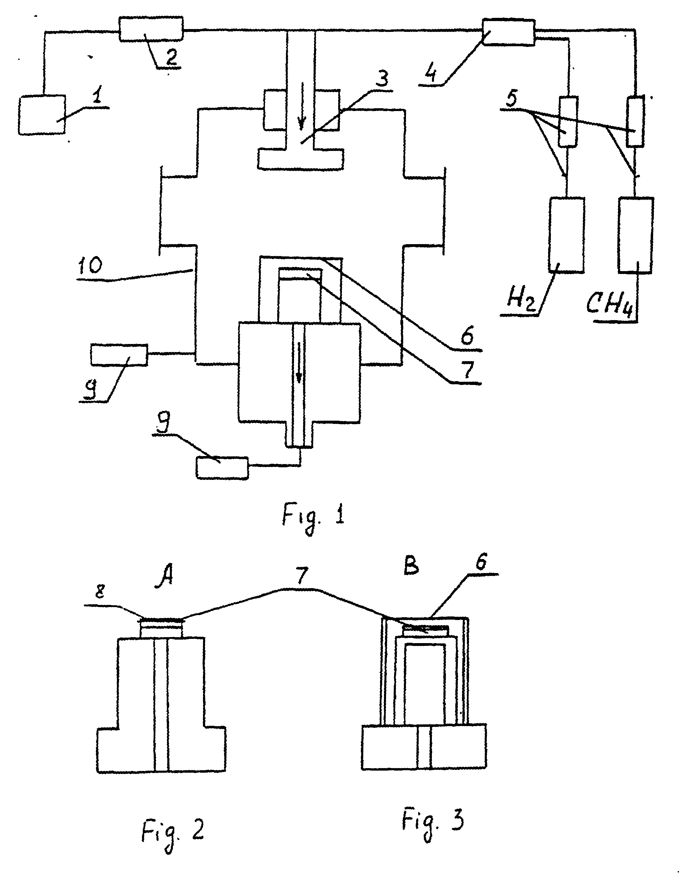

Examples of realization of this invention are given in the following. The experiments are carried out in an installation, schematically shown on **Figure 1,** comprising a power supply source 1, a ballast resistor 2, a cathode 3 preferably made of molybdenum, gas pipes 5, an anode 6 and a substrate holder 7, a substrate 8, vacuum pumps 9 and a reactor chamber 10.

The chamber 10 is pumped out by vacuum pumps 9 until the desired vacuum in the chamber is achieved. Then the hydrogen is supplied to the chamber through one of the gas pipes 5. The DC power supply source 1 provides electrical voltage to the cathode 3 through ballast resistor 2 for breakdown and maintenance of the discharge.

The substrate is heated to the desired temperature (700 °C to 900 °C). If the substrate temperature will be below 700 °C only the graphite phase will be deposited; at the temperatures above 900 °C diamond films would have polycrystalline structure with micrometer size of crystallines.

Another gas pipe 5 is used to admit a carbon containing gas at the concentration within the range 3 to 10 % to the gas flow through a buffer volume 4. The diamond film is deposited at a discharge current density of 3000 to 20000 A/m² (0.3 to 2 A/cm²). There is a discharge instability under the discharge current densities which are higher than 20000 A/cm². A current density lower than 3000 A/cm² is not enough for the desired gas activation.

If the concentration of a carbon containing gas is lower than 3% the growing film has insufficient emission properties, if the concentration is higher than 10 % a graphite film is growing. After the film is deposited the gas inflow again consists of hydrogen only. This is a step of annealing for removing of a graphite layer from the substrate surface.

This invention gives a possibility to make a deposition on both dielectric and conductive substrates, as well on the silicon substrates, which has a good conductivity at the indicated temperature range. Under the deposition on dielectric or conductive substrates placed outside of the discharge gap (**Figure 2**) the anode is preferably made as a grid and the substrate is placed under the anode "down stream" on a grounded or insulated substrate holder outside of the discharge gap.

The anode 6 is preferably made in a form of molybdenum grid from a wire of about 0,1 mm to 1 mm by diameter and with a spacing of 1 mm to 3 mm. The anode 6 is made in the form of a grid from molybdenum wire because of the requirements of high temperature resistance up to 2000 °C, poor sputterability and chemical activity in a flow of hydrogen gas with carbon-containing gas.

The anode made from a wire of less than 0.1 mm by diameter does not allow to pass the required current density. The making of anode in the form of a grid from a wire of more than 1 mm by diameter does not allow to heat it up to a temperature of about 1200 °C. A spacing of less than 1 mm results in a too high shadowing of a substrate, and a spacing of more than 3 mm results in a non uniformity.

Heating up of an anode to a temperature less than 1200 °C does not result in additional thermal activation of the gas mixture, and heating of an anode up to a temperature above 2000 °C results in carbidization of the filaments.

The substrate holder 7 with the substrate 8 is placed under the grid anode 6 (Figure 2) at a distance of 0.1 mm to 5 mm. Placing of the substrate holder at a distance of less than 0.1 mm apart from anode suffers from a poor manufacturability, and placing of the substrate holder at a distance of more than 5 mm results in either deposition of a graphite phase or there is no deposition of any film.

The grid and substrate holder are grounded. The substrate is a silicon which was priory processed by one of the standard methods to increase density of nucleation centres. The power supply source should sustain the current of 1 A to 10 A at a voltage of 500 V to 1000 V. The deposition temperature is 700 °C to 900 °C.

The deposition process on a silicon substrate includes the following stages: The chamber is pumped out up to a pressure of 13 mPa to 130 mPa (10⁻⁴ to 10⁻⁵ Torr). Then hydrogen is brought into the chamber at a pressure between about 7 kPa (50 Torr) and about 40 kPa (300 Torr). The desired voltage for breakdown and maintenance of the discharge is supplied. The substrate is heated to the desired temperature.

The silicon oxide layer is being removed during 10 to 20 minutes. This preferably occurs with hydrogen in the chamber at a discharge current density of the order of 3000 to 20000 A/m² (0.3 to 2 A/cm²).

Then the methane is admitted to the gas flow to achieve a methane concentration from about 7 % to about 12 % and a silicon carbide layer was being formed during 10 to 20 minutes. This layer increases the adhesion of the diamond film to silicon substrate. Also, this layer improves electron injection from the silicon substrate into the diamond film. In case of diamond film deposition on a silicon substrate the desired thickness of silicon carbide layer is not achieved if the methane concentration in the gas flow is lower than 7 %. If the methane concentration is higher than 12%, there is a discharge instability. The time of the carbide layer growth is determined by the rate of growth and desired thickness up to about a few parts of a micron.

Then the methane concentration in the gas mixture is reduced to between about 3 % and about 8 %. In this stage there is a growth of the diamond film with a rate between about 10 µm/hour and about 20 µm/hour. It was proven that the methane as a carbon containing gas gives the films the highest emission parameters. In this case the methane concentration should not be higher than 8 %. After the film is deposited up to the desired thickness (about several microns) the gas inflow again consists of hydrogen only. This is a step of annealing during 5 to 10 minutes for removing of a graphite layer from the substrate surface.

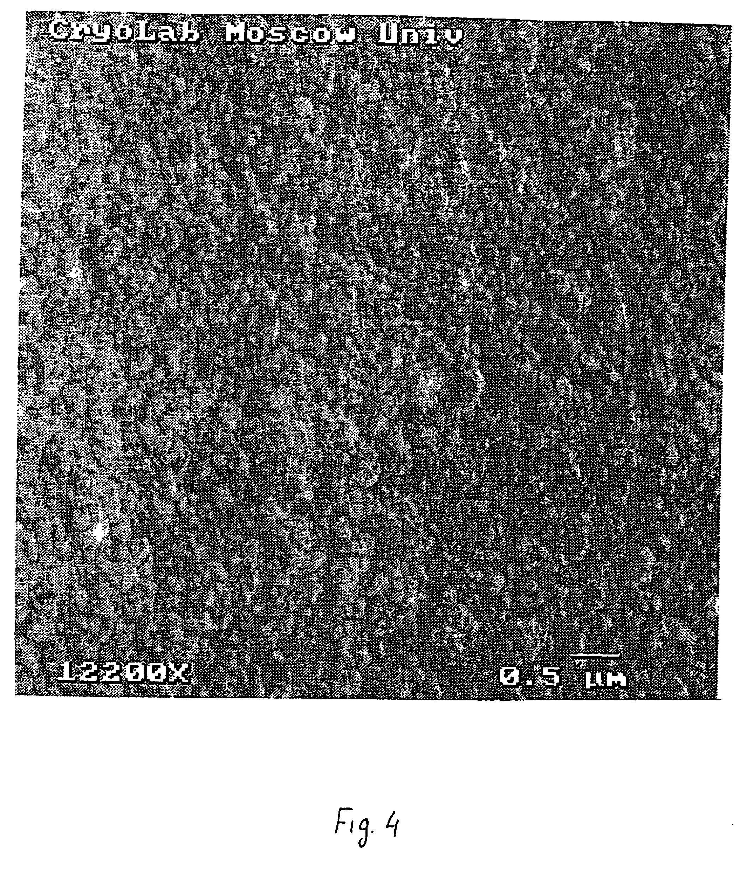

Referring to Figure 4, a scanning electron microscope image of the surface topography of a sample of a nanocrystalline diamond film deposited by the method of this invention is shown. This fact also was confirmed by studying by scanning tunneling microscopy. X-ray diffraction data for a nanocrystalline sample made by the method of this invention resulted in the size of individual crystals to be in the range of about 10 to 50 nm.

The emission characteristics and the data for electric current versus electric field strength of the films made by the method of this invention show that the "turn-on" voltage is very low (there are samples with "tum-on" electric field of about 3 V/µm to 4 V/µm). The current density rapidly increases to above 1000 A/m² (100 mA/cm²). The emission areas are located under an anode wire. In order to achieve a better spatial homogeneity of emission the anode or the substrate is moved back and forth with a frequency of 1 Hz to 100 Hz. As a result, films with homogeneous distribution of the emission current were received.

This invention gives a possibility to make a deposition on both dielectric and conductive substrates. Under the deposition on dielectric or conductive substrates it is possible to use the "down stream" configuration.

The deposition process on metals has some different stages because of various chemical activities of metals and silicon. The chamber is pumped out up to a pressure of 13 mPa to 130 mPa (10⁻⁴ to 10⁻⁵ Torr). Then hydrogen is brought into the chamber at a pressure of between about 7 kPa and about 40 kPa (about 50 Torr and about 300 Torr).

The desired voltage for breakdown and maintenance of the discharge is supplied. The substrate is heated to the desired temperature (700 °C to 900 °C). It is not required the stage for oxide removal. Then the methane is admitted to the gas flow to achieve a methane concentration from about 3 % to about 8 %. In this stage diamond film is grown on the surface. The deposition rate of the film is up to about 10 µm/hour to 20 µm/hour. Because of the high rate of formation of carbide layers for such metals as Mo, W, Ta it is not required a separate stage for formation of carbide layers.

After the film is deposited up to the desired thickness (about several microns) the gas inflow again consists of hydrogen only. This is a step of annealing for removing of a graphite layer from the substrate surface.

As a result the diamond film with the properties close to the described above will be formed.

As a result of the diamond film deposition by the method of this invention a nanocrystalline diamond film is growing. It was shown that this nanocrystalline structure results in producing of diamond films having improved (record) emission current densities, emission threshold, density of emission sites.

The invention has industrial applicability and pertains to a CVD method for forming highly effective films to be used for field emission of electrons. The method gives a possibility to deposit films on the silicon, conductive and dielectric substrates.

The diamond films produced by the method of this invention could be used for manufacturing flat panel displays, in electronic microscopy, microwave electronics and a number of other applications.

## Claims

1. A method to produce a diamond film by chemical vapour deposition, comprising
- the maintenance of a DC glow discharge in a flow of hydrogen in a discharge gap between a cathode and an anode,
- the heating of a substrate up to the deposition temperature,
- the admixing of a carbon containing gas into the flow of hydrogen,
- the deposition of a diamond film in the mixture of hydrogen and the carbon containing gas, and
- the removal of a surplus graphite phase in a discharge in the hydrogen flow,
- **characterized in that** the substrate is heated up to the temperature of 700 °C to 900 °C,
- **that** the deposition of the diamond film is conducted at a current density of 3000 to 20000 A/m² (0.3 to 2 A/cm²) and
- **that** the deposition of the diamond film is conducted at a concentration of a carbon containing gas in the gas flow of 3 to 10 %:

2. The method as claimed in claim 1, **characterized in that** the carbon containing gas is methane at a concentration in the gas flow of 3 % to 8 %.

3. The method as claimed in claim 2, **characterized in that** the deposition of the diamond film is made on a substrate placed on a grounded or insulated substrate holder outside of the discharge gap in a distance of 0.1 mm to 5 mm apart from an anode, and that the anode temperature is 1200 °C to 2000 °C and the methane concentration in the gas flow is 3 % to 8 %, until the desired film thickness is achieved.

4. The method as claimed in claim 3, **characterized in that** the substrate is dielectric or conductive.

5. The method as claimed in any of the preceding claims, **characterized in that** the anode is made from a molybdenum wire 0.1 mm to 1 mm thick forming a grid with a spacing of 1 mm to 3 mm.

6. The method as claimed in claim 1 or 2, **characterized in that** the deposition of the diamond film is made on a conductive substrate placed on an anode at a methane concentration in the gas flow of 3 % to 8%, until the desired film thickness is achieved.

7. The method as claimed in any of the preceding claims,
- **characterized in that** the deposition of the diamond film is made on a silicon substrate where prior to the film deposition a native oxide is removed from the substrate surface in a hydrogen flow,
- **that** then a silicon carbide layer is formed during 10 to 20 minutes on the substrate surface due to admixing into the gas flow of 7 % to 12 % of methane, and
- **that** the deposition of a diamond film is then sequentially performed at a methane concentration in the gas flow of 3 % to 8% until the desired film thickness is achieved.

8. The method as claimed in claim 7, **characterized in that** the removal of the native oxide is made during 10 to 20 minutes in a hydrogen flow at a discharge current density of 3000 to 20000 A/m² (0.3 to 2 A/cm²).

9. The method as claimed in claim 7 or 8, **characterized in that** the forming of the silicon carbide layer is made at a discharge current density of 3000 to 20000 A/m² (0.3 to 2 A/cm²).

## Patentansprüche

1. Verfahren zur Herstellung von Diamantschichten mittels Gasphasensynthese (Chemical vapour deposition), aufweisend
- die Aufrechterhaltung einer Gleichstrom-Glimmentladung in einem Strom aus Wasserstoff in einem Entladungsspalt zwischen einer Kathode und einer Anode,
- das Aufheizen eines Substrates auf die Abscheidungstemperatur,
- das Zumischen von kohlenstoffhaltigem Gas in den Strom aus Wasserstoff,
- die Abscheidung einer Diamantschicht in der Mischung aus Wasserstoff und dem kohlenstoffhaltigen Gas, und
- die Entfernung der überschüssigen Graphitphase in einer Entladung in dem Wasserstoffstrom,
**dadurch gekennzeichnet,**
**dass** das Substrat auf eine Temperatur von 700 °C bis 900 °C aufgeheizt wird,
**dass** die Abscheidung der Diamantschicht bei einer Stromdichte von 3000 bis 20000 A/m² (0,3 bis 2 A/cm²) vorgenommen wird, und
**dass** die Abscheidung der Diamantschicht bei einer Konzentration des kohlenstoffhaltigen Gases in der Gasströmung von 3 bis 10 % erfolgt.

2. Verfahren nach Anspruch 1,
**dadurch gekennzeichnet,**
**dass** das kohlenstoffhaltige Gas Methan mit einer Konzentration in der Gasströmung von 3 % bis 8 % ist.

3. Verfahren nach Anspruch 2,
**dadurch gekennzeichnet,**
**dass** die Abscheidung der Diamantschicht auf einem Substrat auf einem geerdeten oder isolierten Substrathalter außerhalb des Entladungsspaltes in einer Entfernung von 0,1 mm bis 5 mm entfernt von einer Anode durchgeführt wird, und dass die Anodentemperatur 1200 °C bis 2000 °C beträgt und die Methankonzentration in der Gasströmung 3 % bis 8 % beträgt, bis die gewünschte Schichtdicke erreicht wird.

4. Verfahren nach Anspruch 3,
**dadurch gekennzeichnet,**
**dass** das Substrat dielektrisch oder leitend ist.

5. Verfahren nach einem der vorstehenden Ansprüche,
**dadurch gekennzeichnet,**
**dass** die Anode aus einem Molybdändraht von 0,1 mm bis 1 mm Dicke hergestellt wird, der ein Gitter mit Abständen von 1 mm bis 3 mm bildet.

6. Verfahren nach Anspruch 1 oder 2,
**dadurch gekennzeichnet,**
**dass** die Abscheidung der Diamantschicht auf einem auf einer Anode platzierten leitfähigen Substrat bei einer Methankonzentration in der Gasströmung von 3 % bis 8 % vorgenommen wird, bis die gewünschte Schichtdicke erreicht wird.

7. Verfahren nach einem der vorstehenden Ansprüche,
**dadurch gekennzeichnet,**
- **dass** die Ablagerung der Diamantschicht auf einem Siliziumsubstrat erfolgt, in welchem vor der Schichtabscheidung ein vorhandenes Oxid aus der Substratoberfläche in einer Wasserstoffströmung entfernt wird,
- **dass** dann eine Siliziumcarbidschicht während 10 bis 20 min auf der Substratoberfläche, aufgrund einer Zumischung von 7 % bis 12 % an Methan in die Gasströmung gebildet wird, und
- **dass** die Abscheidung einer Diamantschicht dann sequentiell bei einer Methankonzentration in der Gasströmung von 3 % bis 8 % durchgeführt wird, bis die gewünschte Schichtdicke erreicht ist.

8. Verfahren nach Anspruch 7,
**dadurch gekennzeichnet,**
**dass** die Entfernung des vorhandenen Oxides während 10 bis 20 min in einer Wasserstoffströmung bei einer Entladestromdichte von 3000 bis 20000 A/m² (0,3 bis 2 A/cm²) vorgenommen wird.

9. Verfahren nach Anspruch 7 oder 8,
**dadurch gekennzeichnet,**
**dass** die Bildung der Siliziumcarbidschicht bei einer Entladestromdichte von 3000 bis 20000 A/m² (0,3 ibs 2 A/cm²) erfolgt.

## Revendications

1. Procédé de production d'un film de diamant par dépôt chimique en phase vapeur comprenant
- le maintien d'une décharge luminescente de CC dans un flux d'hydrogène dans un espace de décharge entre une cathode et une anode,
- le chauffage d'un substrat jusqu'à la température de dépôt,
- le mélange d'un gaz contenant du carbone dans le flux d'hydrogène,
- le dépôt d'un film de diamant dans le mélange d'hydrogène et du gaz contenant du carbone, et
- l'élimination d'une phase de graphite en excès dans une décharge dans le flux d'hydrogène,
- **caractérisé en ce que** le substrat est chauffé jusqu'à une température de 700 °C à 900 °C,
- **en ce que** le dépôt du film de diamant est effectué à une densité de courant de 3000 à 20000 A/m² (0,3 à 2 A/cm²) et
- **en ce que** le dépôt du film de diamant est effectué à une concentration d'un gaz contenant du carbone dans le flux de gaz de 3 à 10 %.

2. Procédé selon la revendication 1, **caractérisé en ce que** le gaz contenant du carbone est le méthane à une concentration dans le flux de gaz de 3 % à 8 %.

3. Procédé selon la revendication 2, **caractérisé en ce que** le dépôt du film de diamant est effectué sur un substrat placé sur un support de substrat mis à la terre ou isolé en dehors de l'espace de décharge à une distance de 0,1 mm à 5 mm d'une anode, et **en ce que** la température d'anode est de 1200 °C à 2000 °C et la concentration en méthane dans le flux de gaz est de 3 % à 8 %, jusqu'à ce que l'épaisseur de film souhaitée soit obtenue.

4. Procédé selon la revendication 3, **caractérisé en ce que** le substrat est diélectrique ou conducteur.

5. Procédé selon l'une quelconque des revendications précédentes, **caractérisé en ce que** l'anode est constituée d'un fil de molybdène de 0,1 mm à 1 mm d'épaisseur formant une grille d'un espacement de 1 mm à 3 mm.

6. Procédé selon la revendication 1 ou 2, **caractérisé en ce que** le dépôt du film de diamant est effectué sur un substrat conducteur placé sur une anode à une concentration en méthane dans le flux de gaz de 3 % à 8 %, jusqu'à ce que l'épaisseur de film souhaitée soit obtenue.

7. Procédé selon l'une quelconque des revendications précédentes,
- **caractérisé en ce que** le dépôt du film de diamant est effectué sur un substrat de silicium où avant le dépôt du film un oxyde natif est éliminé de la surface du substrat dans un flux d'hydrogène,
- **en ce qu'**une couche de carbure de silicium est formée pendant 10 à 20 minutes sur la surface du substrat du fait du mélange dans le flux de gaz de 7 % à 12 % de méthane, et
- **en ce que** le dépôt d'un film de diamant est ensuite effectué de manière séquentielle à une concentration en méthane dans le flux de gaz de 3 % à 8 % jusqu'à ce que l'épaisseur de film souhaitée soit obtenue.

8. Procédé selon la revendication 7, **caractérisé en ce que** l'élimination de l'oxyde natif est effectuée pendant 10 à 20 minutes dans un flux d'hydrogène à une densité de courant de décharge de 3000 à 20000 A/m² (0,3 à 2 A/cm²).

9. Procédé selon la revendication 7 ou 8, **caractérisé en ce que** la formation de la couche de carbure de silicium est effectuée à une densité de courant de décharge de 3000 à 20000 A/m² (0,3 à 2 A/cm²).
